Europäisches Patentamt

European Patent Office

Office européen des brevets

(11) Publication number: **0 237 029**
**A2**

## (12) EUROPEAN PATENT APPLICATION

(21) Application number: **87103432.8**

(22) Date of filing: **10.03.87**

(51) Int. Cl.4: **H01L 29/76**

(30) Priority: **10.03.86 JP 52873/86**
**21.04.86 JP 92639/86**

(43) Date of publication of application:
**16.09.87 Bulletin 87/38**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Hida, Hikaru c/o NEC Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) **A heterojunction field effect device operable at a high output current with a high withstand voltage.**

(57) A heterojunction field effect transistor includes a first layer of a first semiconductor doped with impurities, a second layer of a second semiconductor having a low impurity concentration and being formed on the first layer, a gate electrode formed on the second layer and source and drain regions formed on both sides of the gate electrode to electrically contact with an interface between the first and second layer. For an N-channel transistor, the electron affinity of the second semiconductor is made smaller than the first semiconductor. For a P-channel transistor, the sum of electron affinity and energy band-gap is made larger than the first semiconductor.

FIG. 1 (A)

EP 0 237 029 A2

# A HETEROJUNCTION FIELD EFFECT DEVICE OPERABLE AT A HIGH OUTPUT CURRENT WITH A HIGH WITHSTAND VOLTAGE

BACKGROUND OF THE INVENTION

(Field of the Invention)

This invention relates to a field effect transistor operable at high speed, and more particularly to a heterojunction field effect transistor having improved output current and input withstand voltage.

(Description of the Related Art

As a high speed field effect transistor, a heterojunction field effect transistor using two-dimensional electron gas (hereinafter, referred as 2-DEG) has been proposed in U.S.P. 4,424,525 granted on January 3, 1984 for Takashi Mimura. The 2-DEG is produced at an interface between an AℓGaAs layer doped with N-type impurities and a high purity GaAs layer and has a high mobility. The similar structures of heterojunction field effect transistor are seen in "IEEE Electron Device Letters", Vol. EDL-5, No. 9 (September 1984), PP 379 -381, "Applied Physics Letters", Vol. 40, No. 6 (March 15, 1982) PP 530 -532 and "IEEE Transactions on Electron Devices", Vol. ED-31, No. 1 (January 1984), PP 29 -35.

In the proposed heterojunction field effect transistor, a gate electrode is formed directly on the N-type AℓGaAs layer which is highly doped with N-type impurities to produce the 2-DEG. Therefore, a withstand voltage at the gate electrode is low.

Moreover, since the N-type impurities are contained in the AℓGaAs layer, activated electron density in the 2-DEG does not become high due to Aℓ elements in the AℓGaAs layer. An output current is not made large, resulted in a poor driving capability of load and a limited improvement of a mutual conductance gm. The low activated electron density causes a change in a threshold voltage $V_T$, so-called a short-channel effect, when a channel length is made very short.

"IEEE Transactions on Electron Devices" Vol. ED-31, No. 8 (August 1984), PP 1032 -1037 restrained the short-channel effect by making an impurity concentration of channel region in GaAs Schottky-gate FET higher. However, as above-mentioned, the breakdown voltage of the Schottky gate becomes lower by use of the channel region having a high impurity concentration. Furthermore, the GaAs FET has a classic type of structure in which a single GaAs layer is used as the channel region. Thus, since the 2-DEG is not used, electrons do not show the expected high mobility by interference of impurity atoms.

The improvement of active electron density in a channel region of a heterojunction FET using the 2-DEG has proposed in a US patent application of a serial No. 624,333 assigned to the same assignee. The proposed improvement is the use of modulation-doped superlattice in the channel region. A Schottky gate is attached to the modulation-doped superlattice. The modulation-doped superlattice is multi-layer structure of impurity-doped GaAs layers and high-purity AℓAs layers. Since the impuries are not contained in the AℓAs layers but in the GaAs layers, the 2-DEG having a large density of activated electrons is induced at the interface between the impurity-doped GaAs and high-purity AℓAs layers. Therefore, the short-channel effect can be effectively restrained. However, a thickness of the high-purity AℓAs layers is limited to a value lower than electron wavelength. Such thickness is not sufficient to use the high-purity AℓAs layer as a layer contacting with a gate electrode for improving an input withstand voltage.

SUMMARY OF THE INVENTION

It is, therefore, a major object of the present invention to provide a heterojunction field effect transistor operable at a high speed with a large output current and having a high input withstand voltage.

The heterojunction field effect transistor according to the present invention includes a first layer of an N-type semiconductor having a first electron affinity, a second layer of a high-purity semiconductor formed on and in contact with the first layer and having a second electron affinity smaller than the first electron affinity, a gate electrode formed on the second layer and source and drain regions formed on both sides of the gate electrode in contact with an interface between the first and second layers.

Another feature of the present invention is a P-channel type heterojunction field effect transistor including a first layer of a P-type semiconductor having a first electron affinity and a first energy band-gap, a second layer of a high-purity semiconductor formed on and in contact with the first layer and having a second electron affinity and a second energy band-gap, the sum of the second electron affinity and the second energy band-gap being larger than the sum of the first electron affinity and the first energy band-gap, a gate electrode formed on the second layer and source and drain regions formed on both sides of the gate electrode in contact with an interface between the first and second layers.

In the present invention, the gate electrode is formed on the second layer of a high-purity semiconductor. The gate electrode may form a Schottky junction with the second layer. The gate electrode may be formed of a semiconductor layer of P-type for the N-type first layer or N-type for the P-type first layer, thus constituting P-i-N or N-i-P structure. Since the electric field applied to the gate electrode is weakened by the high-purity second layer, the junction between the gate electrode and the second layer has a high breakdown voltage. In other words, the heterojunction field effect transistor of the present invention has a high input withstand voltage.

At an interface between the first and second layers, a channel of electrons of a higher density than the impurity density contained in the second layer is formed when a voltage higher than a flat-band voltage is applied to the gate electrode. In this situation where the electron density is larger than an impurity density, Coulomb's scattering due to ionized impurities is restrained. The effective mobility of electron is now lowered by the ionized impurities and shows a theoritically expected high value. Due to such high effective mobility, a high speed operation is achieved.

The high electron density increases an output current to show a high mutual conductance. In addition, the high electron density suppress the variation in a threshold voltage when a channel length is shortened. In other words, the heterojunction field effect transistor according to the present invention can make the channel length small without changing its threshold voltage to achieve very high speed operation.

## BRIEF DESCRIPTION OF THE DRAWINGS

The above and further objects, features and advantages of the present invention will become more apparent from the following detailed description of embodiments taken in conjunction with the accompanying drawings, wherein:

Fig. 1(a) is a sectional view of a first embodiment according to the present invention, Fig. 1(b) is an energy band diagram of a portion under the gate electrode of the first embodiment at a thermal equilibrium, and Fig. 1(c) is an energy band diagram of a portion under the gate electrode of the first embodiment when a voltage is applied to the gate electrode;

Fig. 2 is a sectional view of a second embodiment according to the present invention;

Fig. 3(a) is a sectional view of a third embodiment according to the present invention, and Fig. 3(b) is an energy band diagram of a portion under the gate electrode of the third embodiment;

Fig. 4(a) is a sectional view of a fourth embodiment according to the present invention, Fig. 4(b) is an energy band diagram of a portion under the gate electrode of the fourth embodiment at a thermal equilibrium, and Fig. 4(c) is an energy band diagram of a portion under the gate electrode of the fourth embodiment when a voltage is applied to the gate electrode;

Fig. 5 is a sectional view of a fifth embodiment according to the present invention; and

Fig. 6(a) is a sectional view of a sixth embodiment according to the present invention, and Fig. 6(b) is an energy band diagram of a portion under the gate electrode of the sixth embodiment at a thermal equilibrium.

## DESCRIPTION OF THE EMBODIMENTS

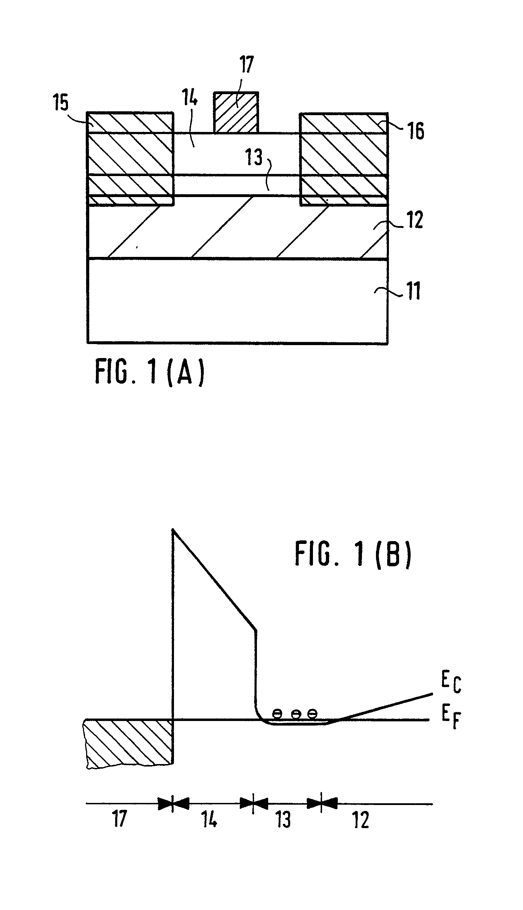

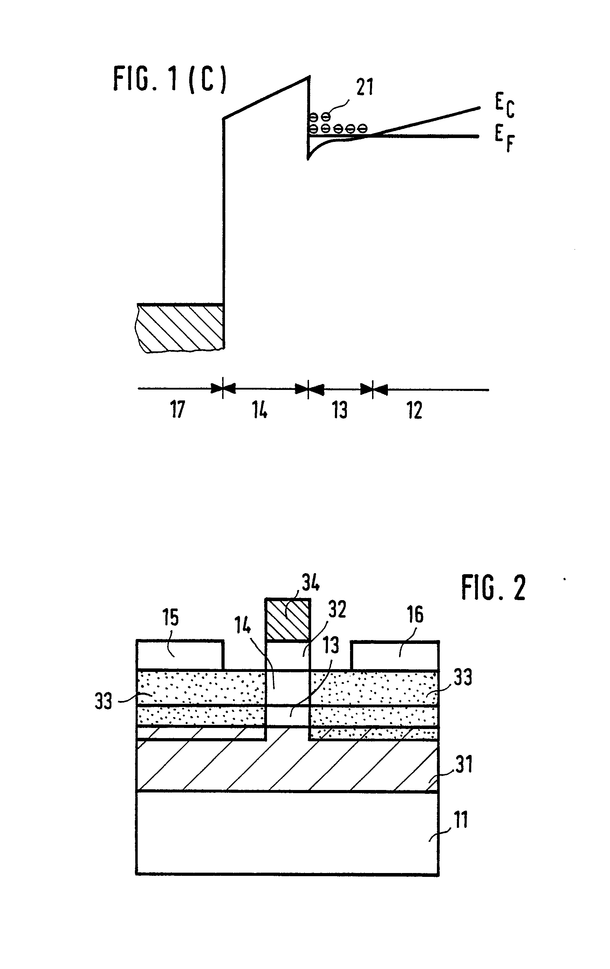

The first embodiment shown in Fig. 1(a) is an N-channel type heterojunction field effect transistor. On a semi-insulating GaAs substrate 11, a GaAs layer 12 is formed as a buffer layer. The GaAs layer 12 may have a thickness of 5,000 Å and an impurity concentration lower than $1 \times 10^{15}$ cm$^{-3}$. An N-type GaAs layer 13 having a concentration of donor impurities higher than $5 \times 10^{17}$ cm$^{-3}$. - ($3 \times 10^{18}$ cm$^{-3}$ in this example) and a thickness and a thickness of 100 Å is deposited on the GaAs layer 12. A high-purity $A\ell_{0.3}Ga_{0.7}As$ layer 14 having an impurity concentration less than $1 \times 10^{16}$ cm$^{-3}$, typically $1 \times 10^{15}$ cm$^{-3}$, is deposited on the N-type GaAs layer 13 with a thickness of 20 Å. $A\ell$ is selectively formed on a portion of the high purity $A\ell$GaAs layer 14 as a gate electrode 17 forming a Schottky contact with the $A\ell$GaAs layer 14. On both sides of the gate electrode 17, donor impurities are implanted into the $A\ell$GaAs layer 14, the N-type GaAs layer 13 and the semi-insulating buffer layer 12 with a high impurity concentration to form source and drain regions on which source and drain electrodes 15 and 16 are formed with an alloy of Au/Ge/Ni.

At the thermal equilibrium, an energy band structure of a lower end $E_C$ of conduction band becomes as shown in Fig. 1(b) at a portion under a gate electrode 17. The Fermi level $E_F$ is shown together with the lower end $E_C$ of the conduction band. Electrons as carriers are distributed over the N-type GaAs layer 13.

When a voltage $V_G$ higher than a flat-band voltage $V_{FB}$ is applied to the gate electrode 17, the energy band structure changes as shown in Fig. 1-(c). Under this condition, since the gate electrode 17 forms a Schottky contact with a high-purity AℓGaAs layer 14, the electric field applied to the Schottky junction becomes small, resulted in a high breakdown voltage. In the first embodiment, the breakdown voltage at the gate electrode 17 was more than 10 volts. The drain withstand voltage was about 20 volts.

When the voltage $V_G$ higher than the flat-band voltage $V_{FB}$ is applied to the gate electrode 17, a high-density electron layer 21 is formed at an interface between the high-purity AℓGaAs layer 14 and the N-type GaAs layer 13. The electron density in the interface will now be estimated. In the high-purity AℓGaAs layer 14, the electron density $Q_S$ can be expressed as follows:

$$Q_S = \epsilon E/q \text{ ....... (1)}$$

where $\epsilon$ is a dielectric constant, E is a surface electric field, and q is charge of an electron. The impurity density of the high-purity AℓGaAs layer 14 is assumed as zero and the dielectric constant $\epsilon$, as $12 \bullet \epsilon_0$ ($\epsilon_0$ is a dielectric constant in vacuum), for simplification of estimation. When the gate voltage $V_G$ is higher than the flat-band voltage $V_{FB}$ by 1 volt, the electric field E is 0.5 mega V/cm. Thus, the electron density $Q_S$ in the high-purity AℓGaAs layer 14 becomes $3.3 \times 10^{12}$ cm$^{-2}$. On the other hand, since the N-type GaAs layer 13 has an impurity concentration of $3 \times 10^{18}$ cm$^{-3}$ and a thickness of 100 Å, the electron density becomes $3 \times 10^{12}$ cm$^{-2}$. The total electron density in the channel region at the interface between the high-purity AℓGaAs layer 14 and the N-type GaAs layer 13 becomes $6.3 \times 10^{12}$ cm$^{-2}$ which is larger than the impurity concentration of $3 \times 10^{18}$ cm$^{-3}$ in the N-type GaAs layer 13.

This large electron density allows a large output current. The first embodiment showed a maximum intrinsic mutual conductance of about 500 mili siemens/mm. A current of 650 mA is obtained per one mm of a channel width. Furthermore, this high electron density in the channel region suppress the change in threshold voltage when a channel length is shortened. In other words, the channel length can be made short without change in the threshold voltage for improving the high speed operation.

The high speed operation is also improved by the high electron density higher than the impurity concentration. When the electron density is larger than the impurity concentration, the coulomb's scattering due to ionized impurities is suppressed. Therefore, since electrons show the theoritically expected high mobility, the high speed operation is improved.

The N-type layer 13 may be formed of InGaAs which has an electron affinity larger than GaAs to further improve the electron density in the channel region and electron mobility.

Next, a second embodiment will be explained with reference to Fig. 2 in which same reference numerals are used for the same material as Fig. 1. On a semi-insulating GaAs substrate 11, a p$^-$-type GaAs layer 31 is formed as a buffer layer with a thickness of 5,000 Å and an acceptor concentration of $1 \times 10^{16}$ cm$^{-3}$. An N-type GaAs layer 13 having a donor concentration higher than $5 \times 10^{17}$cm$^{-3}$ ($3 \times 10^{18}$cm$^{-3}$ in this example) or higher and a thickness of 200 Å is formed on the P$^-$-type GaAs layer 31. A high-purity Aℓ$_{0.3}$Ga$_{0.7}$As layer 14 having an impurity concentration less than $1 \times 10^{16}$ cm$^{-3}$, typically $1 \times 10^{15}$ cm$^{-3}$, and a thickness of 100 Å is formed on the N-type GaAs layer 13. On the high-purity AℓGaAs layer 14, a P-type GaAs layer 32 having an acceptor concentration higher than $1 \times 10^{18}$ cm$^{-3}$, typically $3 \times 10^{19}$ cm$^{-3}$, and a thickness of 200 Å is selectively formed. An electrode 34 for gate is formed on the P-type GaAs layer 32 with tungsten. On both sides of the electrode 34 and the P-type GaAs layer 32, donor impurities are implanted into the N-type GaAs layer 31, the high-purity AℓGaAs layer 14, the N-type GaAs layer 13 and the P$^-$-type GaAs layer 31 with a concentration of $5 \times 10^{18}$ cm$^{-3}$ to form source and drain regions 33 on which source and drain electrodes 15 and 16 are formed with an alloy of Au/Ge/Ni. The source and drain regions 33 may be alternatively formed with a selective vapor-deposition of N-type GaAs having a donor concentration of $5 \times 10^{18}$ cm$^{-3}$.

In this embodiment, a P-i-N junction is formed of the P-type GaAs layer 32, the high-purity AℓGaAs layer 14 and N-type GaAs layer 13. The gate voltage is applied to the interface between the high-purity AℓGaAs layer 14 and the N-type GaAs layer 13 through the P-type GaAs layer 32 and the high-purity AℓGaAs layer14 to modulate the electron density in the interface. The other operational mechanism is similar to the first embodiment. A high speed operation, a large output current, a high mutual conductance and a suppressed short-channel effect are similarly obtained.

Since the high-purity $A\ell$GaAs layer 14 has a high resistivity, the electric field applied to the P-i-N junction via the gate electrode is weaked by the high-purity $A\ell$GaAs layer 14 to obtain a high breakdown voltage of the P-i-N junction. Thus, a high input withstand voltage is achieved.

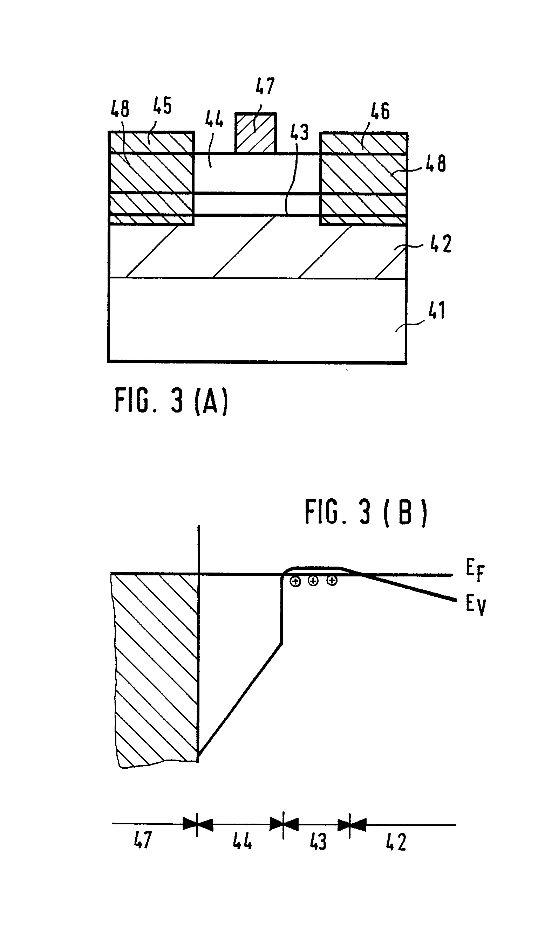

A third embodiment shown in Figs. 3(a) and 3-(b) is a P-channel type heterojunction field effect transistor. A semi-insulating GaAs substrate 41 is used. A high-purity Ge layer 42 having a carrier density less than $1 \times 10^{15}$ cm$^{-3}$ is formed on the GaAs substrate 41 as a buffer layer with a thickness of about 1 $\mu$m. A P-type Ge layer 43 is formed on the high-purity Ge layer 42 with an acceptor concentration higher than $5 \times 10^{17}$ cm$^{-3}$, typically $3 \times 10^{18}$ cm$^{-3}$, and a thickness of 100 Å. A high-purity GaAs layer 44 having an impurity concentration less than $1 \times 10^{16}$ cm$^{-3}$, typically $1 \times 10^{15}$ cm$^{-3}$, and a thickness of 200 Å is formed on the P-type Ge layer 43. $A\ell$ is deposited on a part of the high-purity GaAs layer 44 to form a gate electrode 47. Acceptor impurities are implanted into the high-purity GaAs layer 44, the P-type Ge layers 42 and 43 to form source and drain regions 48 on both sides of the gate electrode 47. Source and drain electrodes 45 and 46 is formed by attaching an alloy of Au/Zn to the source and drain regions 48.

An energy band diagram at a thermal equilibrium of a potion under the gate electrode 47 of the third embodiment is shown in Fig. 3(b) in which an upper edge $E_V$ of the valence band and a Fermi level $E_F$ are demonstrated. Holes generated by the acceptor impurities in the P-type Ge layer 43 are distributed over the P-type Ge layer 43. When a voltage $V_G$ lower than a flat-band voltage $V_{FB}$ is applied to the gate electrode 47, the holes generated by the acceptor impurities and holes generated by a field applied to the high-purity GaAs layer 44 are collected at an interface between the P-type Ge layer 43 and the high-purity GaAs layer 44. At the interface, the hole density becomes deeper than the acceptor concentration. Under such condition, coulomb's scattering due to ionized impurities is suppressed to raise the effective mobility of holes, causing a high speed operation of the heterojunction field effect transistor. The increased hole density raises an output current to improve an output driving capability and suppresses the change in threshold voltage when a channel length is shortened. Furthermore, since the gate electrode 47 contacts the high-purity GaAs layer 44 to form a Schottky junction, the breakdown voltage of the Schottky junction is high. A high input withstand voltage is obtained.

As a modification of the third embodiment, N-type GaAs layer may be interposed between the gate electrode 47 and the high-purity GaAs layer 44.

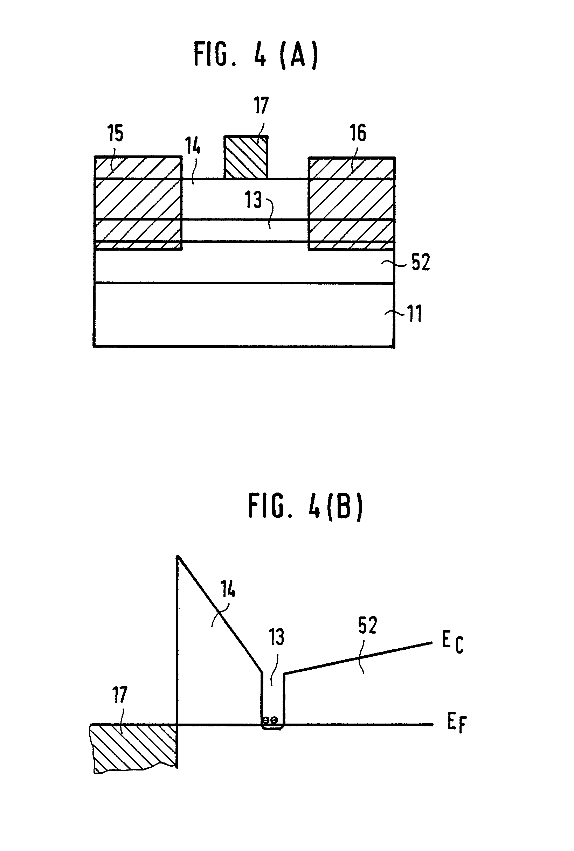

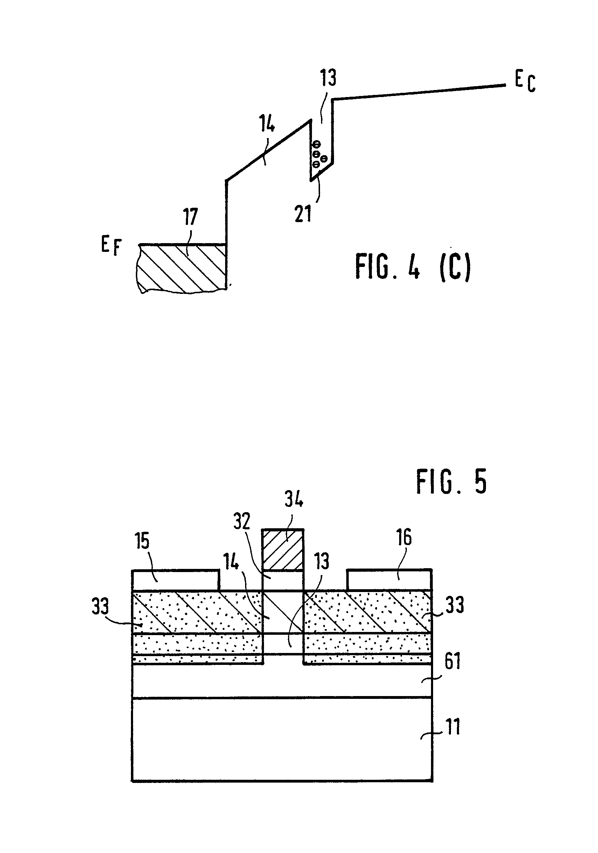

A fourth embodiment shown in Figs. 4(a), 4(b) and 4(c) is another N-channel heterojunction field effect transistor which has a structure similar to the first embodiment. The same reference numerals are used to show the same material as Figs. 1(a), 1(b) and 1(c). A material interposed between the semi-insulating GaAs substrate 11 and the N-type GaAs layer 13 is different from the first embodiment and is an $A\ell_x$Ga$_{1-x}$As layer 52 having an impurity concentration lower than $1 \times 10^{16}$ cm$^{-3}$, typically $1 \times 10^{15}$ cm$^{-3}$, and a thickness of 5,000 Å. The value "x" in the $A\ell_x$Ga$_{1-x}$As is zero at a surface of the $A\ell_x$Ga$_{1-x}$As layer 52 contracting the semi-insulating GaAs substrate and increased gradually up to a value of 0.3 at the other surface contacting the N-type GaAs layer 13. The same features and advantages as the first embodiment are obtained.

Mooreover, by using the $A\ell_x$Ga$_{1-x}$As layer 52, a short-channel effect is more effectively suppressed. At the thermal equilibrium, electrons generated by the donor impurities in the N-type GaAs layer 13 are exclusively distributed in the N-type GaAs layer 13 as shown in Fig. 4(b). When a voltage $V_G$ higher than the flat-band voltage $V_{FB}$ is applied to the gate electrode 17, the holes generated by the donor impurities and holes generated by electric field in the high-purity $A\ell$GaAs layer 14 are collected at the interface between the N-type GaAs layer 13 and the high-purity $A\ell$GaAs layer 14 to form a high density electron layer 21 as shown in Fig. 4(c). The potential level of the lower edge $E_C$ of the conduction band forms a deep well at the N-type GaAs layer. The electrons in the high density electron layer 21 do not spread out from the N-type GaAs layer 13 to keep high density. Therefore, even if the channel length becomes short, the electron density in the channel region is kept high to suppress the change in threshold voltage. Actually, when the channel length is shortened from 10 $\mu$m to 0.5 $\mu$m, the change in threshold voltage was at most -0.2 volts.

A fifth embodiment shown in Fig. 5 has a structure similar to the second embodiment of Fig. 2. The difference is a use of a P$^-$-type $A\ell_x$Ga$_{1-x}$As layer 61 between the semi-insulating GaAs substrate 11 and the N-type GaAs layer 13. The P$^-$-type $A\ell_x$Ga$_{1-x}$As layer has an acceptor concentration lower than $10^{16}$ cm$^{-3}$ and a thickness of 5,000 Å. The value "x" is zero at a surface contacting the semi-insulating GaAs substrate 11 and is gradually raised up to 0.3 at the other surface contacting the N-type GaAs layer 13.

The features and advantages of a high speed operation, a high input withstand voltage, a large output current and a high mutual conductance are similar to other embodiment. The suppression of the short-channel effect is similar to the fourth embodiment but is more improved by using a P-type material as the $Al_xGa_{1-x}As$ layer 61. The lower edge of the conduction band of the $Al_xGa_{1-x}As$ layer 61 is raised by making it a P-type. The electrons in the high density electron layer 21 is more difficult to scatter from the high density electron layer 21. Thus, the change in threshold voltage at a shortenned channel length is more small.

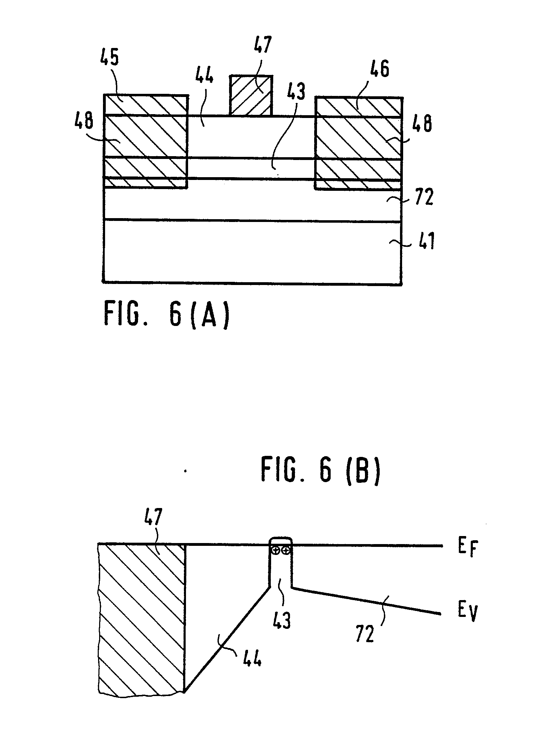

A sixth embodiment shown in Figs. 6(a) and 6-(b) has a structure similar to the third embodiment of Figs. 3(a) and 3(b). A difference is a use of a high purity GaAs layer 61 having an impurity concentration lower than $1 \times 10^{15}$ cm$^{-3}$ and a thickness of about 1 μm. Similar to other embodiments, the features and advantages of a high speed operation, a high input withstand voltage, a large output current and a high mutual conductance are achieved in the sixth embodiment. The upper edge of valence band of GaAs is lower than Ge. The potential well for holes is formed at the P-type Ge layer 43 as shown in Fig. 6(b). The suppression of the short-channel effect is more effective, compared to the third embodiment.

As a modification of the sixth embodiment, an N-type GaAs layer may be interposed between the gate electrode 47 and the high-purity GaAs layer 44.

Although sever embodiment has been explained, the present invention is apparently not limited to those embodiment. For the N-channel type heterojunction field effect transistor, donor impurities are contained in the semiconductor having an electron affinity larger than another semiconductor contacting the former semiconductor. The examples of combination of a semiconductor doped with donor impurities and another semiconductor contacting thereto are GaAs-AlGaAs, InGaAs-GaAs, InGaAs-InAlAs, Ge-SiGe, InP-InAlAs, InP-AlGaAs and InP-GaAs. On the other hand, for the P-channel type heterojunction field effect transistor, acceptor impurities are contained in a semiconductor having a sum of electron affinity an energy band-gap smaller than another semiconductor contacting the former semiconductor. The examples of combination of the semiconductor doped with acceptor impurities and another semiconductor contacting thereto are Ge-GaAs, Ge-AlGaAs and GaAs-AlGaAs.

## Claims

1. A heterojunction field effect transistor comprising:
a first layer formed of a first semiconductor doped with donor impurities and having a first electron affinity;
a second layer formed on said first layer to form an interface between said first and second layers, said second layer being formed of a second semiconductor having a low impurity concentration and a second electron affinity smaller than said first electron affinity;
a gate electrode formed on said second layer; and
source and drain electrodes formed on both sides of said gate electrode to electrically contact with said interface between said first and second layers.

2. A heterojunction field effect transistor as claimed in claim 1, wherein said first semiconductor has an impurity concentration higher than $5 \times 10^{17}$ cm$^{-3}$, said second semiconductor having an impurity concentration lower than $1 \times 10^{16}$ cm$^{-3}$.

3. A heterojunction field effect transistor as claimed in claim 1, wherein said gate electrode contacts with said second layer to form a metal-semiconjunctor rectifying junction.

4. A heterojunction field effect transistor as claimed in claim 3, said heterojunction field effect transistor further comprising a third layer on which said first layer is formed, said third layer including a third semiconductor having a third electron affinity smaller than said first electron affinity.

5. A heterojunction field effect transistor as claimed in claim 3, wherein a combination of said first and second semiconductors is selected from a group of combinations consisted of GaAs-AlGaAs, InGaAs-GaAs, InGaAs-InAlAs, Ge-SiGe, InP-InAlAs, InP-AlGaAs and InP-GaAs.

6. A heterojunction field effect transistor as claimed in claim 1, wherein said gate electrode includes a fourth layer of a fourth semiconductor contained with acceptor impurities, said fourth semiconductor contacting with said second layer.

7. A heterojunction field effect transistor as claimed in claim 6, said heterojunction field effect transistor further comprising a fifth layer on which said first layer is formed, said fifth layer including a fifth semiconductor having a fourth electron affinity smaller than said first electron affinity.

8. A heterojunction field effect transistor as claimed in claim 6, wherein a combination of said first and second semiconductors is selected from a group of combinations consisting of GaAs-AlGaAs, InGaAs-GaAs, InGaAs-InAlAs, Ge-SiGe, InP-InAlAs, InP-AlGaAs and InP-GaAs.

9. A heterojunction field effect transistor comprising;
a first layer formed of a first semiconductor doped with acceptor impurities and having a first sum of electron affinity and energy band-gap;
a second layer formed on said first layer to form an interface between said first and second layer, said second layer being formed of a second semiconductor having a low impurity concentration and a second sum of electron affinity and energy band-gap larger than said first sum;
a gate electrode formed on said second layer; and

source and drain electrodes formed on both sides of said gate electrode to electrically contact with said interface between said first and second layers.

10. A heterojunction field effect transistor as claimed in claim 9, wherein said first semiconductor has an im impurity concentration higher than $5 \times 10^{17}$ cm$^{-3}$, said second semiconductor having an impurity concentration lower than $1 \times 10^{15}$ cm$^{-3}$.

11. A heterojunction field effect transistor as claimed in claim 9, wherein a combination of said first and second semiconductors is selected from a group of combinations consisted of Ge-GaAs, Ge-AℓGaAs and GaAs-AℓGaAs.

12. A heterojunction field effect transistor as claimed in claim 9, wherein said gate electrode forms a metal-semiconductor rectifying junction with said second layer.

13. A heterojunction field effect transistor as claimed in claim 9, wherein said gate electrode includes a fourth layer of a fourth semiconductor doped with donor impurities, said fourth layer contacting with said second layer.

14. A heterojunction field effect transistor as claimed in claim 9 and further comprising a third layer on which said first layer is formed, said third layer being formed of a third semiconductor having a third sum of electron affinity and energy band-gap larger than said first sum.

15. A heterojunction field effect transistor as claimed in claim 14, wherein said gate electrode forms a metal-semiconductor rectifying junction with said second layer.

16. A heterojunction field effect transistor as claimed in claim 14, wherein said gate electrode includes a fifth layer of a fifth semiconductor doped with donor impurities, said fifth layer contacting with said second layer.

17. A heterojunction field effect transistor comprising a first semiconductor layer doped with impurities at an impurity concentration, a second semiconductor layer formed on said first semiconductor layer and forming a channel region at an interface between said first and second semiconductor layer, and a gate electrode formed on said second semiconductor layer, said gate electrode being applied with an input voltage to induce a carrier density in said channel region which is larger than a carrier density determined by said impurity concentration in said first semiconductor layer.

18. A heterojunction field effect transistor as claimed in claim 1, wherein electrons having a density larger than an electron density determined by an impurity concentration of said donor impurities are induced in said interface between said first and second layers in accordance with a voltage applied to said gate electrode.

19. A heterojunction field effect transistor as claimed in claim 9, wherein holes having a density larger than a hole density determined by an impurity concentration of said acceptor impurities are induced in said interface between said first and second layers in accordance with said gate electrode.

FIG. 1 (A)

FIG. 1 (B)

## FIG. 1 (C)

21

$E_C$

$E_F$

17   14   13   12

## FIG. 2

34

15   14   32   16

33

33

13

31

11

FIG. 3 (A)

FIG. 3 ( B )

# FIG. 4 (A)

# FIG. 4(B)

FIG. 4 (C)

FIG. 5

FIG. 6(A)

FIG. 6 (B)